# DEMANDE DE BREVET EUROPEEN

(11) **EP 0 872 849 A1**
(43) Date de publication de la demande: **21.10.1998**
(21) Numéro de dépôt: 98460009.8
(22) Date de dépôt: 09.04.1998
(51) Int. Cl.: G11C 16/06, G11C 7/00

(54) **Circuit de lecture de mémoire avec dispositif de limitation de précharge.**

(30) Priorité: 16.04.1997 FR 9704926
(71) Demandeur: SGS-THOMSON MICROELECTRONICS S.A., 94250 Gentilly (FR)
(72) Inventeur: Yero, Emilio Miguel, Cabinet Ballot-Schmit, 56100 Lorient (FR)
(74) Mandataire: Ballot, Paul

(57) **Abrégé**

La présente invention concerne un circuit de lecture de mémoire avec dispositif de limitation de la précharge des ligne de bits. Le circuit se caractérise en ce qu'il comporte des moyens formant miroir de courant (TN1, TN2, TN3) et assurant d'autre part une précharge contrôlée de la ligne de bit et de la ligne de référence en limitant le potentiel de précharge à une valeur limite référencée par rapport à la masse.

Application dans le domaine des mémoires non volatiles (EEPROM, flash EPROM) et tout particulièrement les mémoires alimentées avec de faibles tensions.

## Description

La présente invention concerne un circuit de lecture de mémoire avec dispositif de limitation de la précharge des ligne de bits. Elle trouve son application dans le domaine des mémoires non volatiles (EEPROM, flash EPROM) et concerne tout particulièrement les mémoires alimentées avec de faibles tensions.

Les mémoires sont organisées en réseaux de cellules, les cellules d'une même colonne étant reliées à une ligne de bit et les cellules d'une même rangée étant reliées à une ligne de mot. La ligne de bit permet de transmettre une information sur l'état d'une cellule mémoire située au croisement de cette ligne de bit et d'une ligne de mot sélectionnée. Cette information est ensuite traitée par un circuit de lecture pour déterminer l'état de la cellule mémoire.

Dans une mémoire EEPROM, les cellules peuvent être dans un état vierge, dans lequel elles laissent passer un courant électrique de référence, dans un état effacé, dans lequel elles laissent passer un courant supérieur au courant de référence, ou dans état programmé, dans lequel elles s'opposent au passage d'un courant. Pour lire l'information, on cherche à détecter la présence d'un courant circulant dans la ligne de bit reliée à une cellule à lire : un tel courant est présent si la cellule est effacée ou vierge, sinon elle est programmée.

Pour détecter la présence du courant, on utilise une ligne de référence semblable à la ligne de bit; cette ligne de référence est parcourue par le courant de référence pendant une phase de lecture. Ce courant de référence peut par exemple être fourni par une cellule de référence. La phase de lecture d'une cellule mémoire est précédée d'une phase de précharge de la ligne de bit et de la ligne de référence. Pendant cette phase, la ligne de bit et la ligne de référence sont préchargées à un potentiel de l'ordre de 1 volt. On limite ce potentiel à 1 volt afin d'éviter tout stress des cellules raccordées à la ligne de bit. Pendant la phase de lecture, le courant circulant dans la ligne de bit est comparé au courant de référence pour déterminer si la cellule lue est programmée ou effacée.

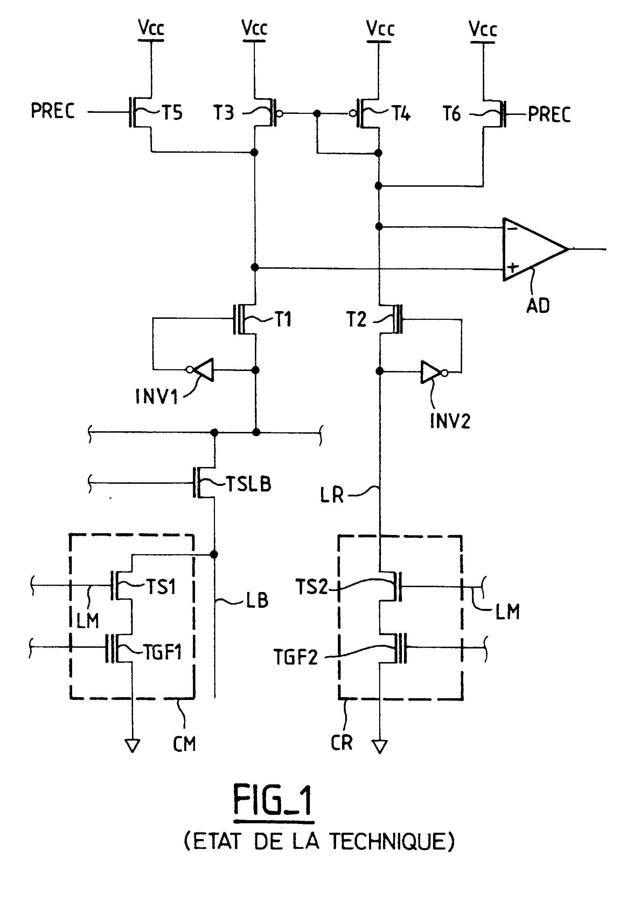

La figure 1 représente de manière simplifiée un circuit de lecture de l'art connu.

Une cellule mémoire CM, située au croisement d'une ligne de mot LM et d'une ligne de bit LB est sélectionnée par la ligne de mot et délivre une information sur la ligne de bit. De manière classique, la cellule mémoire CM est constituée d'un transistor à grille flottante TGF1 monté en série avec un transistor de sélection TS1. La grille de commande du transistor de sélection TS1 est reliée à la ligne de mot LM alors que la grille de commande du transistor TGF1 reçoit une tension de lecture pendant la phase de lecture. La ligne de bit LB est sélectionnée par un transistor de sélection de ligne de bit TSLB. La ligne de bit LB est préchargée en tension, pendant une phase de précharge, par un transistor de précharge T1 qui a pour fonction de fournir un courant de précharge à la ligne de bit tout en limitant le potentiel de précharge à une valeur déterminée, de 1 volt environ.

Une ligne de référence LR dont les caractéristiques sont très similaires à celles de la ligne de bit LB, notamment du point de vue des capacités parasites, est également préchargée à un potentiel d'environ 1 volt par un transistor de précharge T2. Dans l'exemple de la figure 1, la ligne de référence LR est reliée à une cellule de référence CR constituée d'un transistor de sélection TS2 monté en série avec un transistor à grille flottante TGF2. Pendant la phase de lecture, une tension de lecture est appliquée sur la grille de commande du transistor TGF2 et la ligne de référence est alors parcourue par un courant de référence.

Pour limiter la précharge de la ligne de bit LB et de la ligne de référence LR à 1 volt, les transistors T1 et T2 sont rebouclés sur eux-mêmes par des portes inverseuses INV1 et INV2. Ainsi, la source et la grille de commande du transistor T1 sont respectivement connectées à l'entrée et à la sortie de la porte inverseuse INV1. De même, la source et la grille de commande du transistor T2 sont respectivement connectées à l'entrée et à la sortie de la porte inverseuse INV2. Ces quatre éléments forment alors un dispositif de limitation de précharge des lignes LB et LR. Pour obtenir le potentiel de précharge recherché, on détermine la taille des transistors de la porte inverseuse en fonction de la capacité équivalente de la ligne de bit et de la ligne de référence.

Pour lire l'état des cellules, on effectue une comparaison entre le courant consommé par la ligne de bit et le courant de référence. Plus précisément, on compare le courant consommé par la ligne de bit à un courant qui est une fraction du courant consommé par la cellule de référence.

Pour ce faire, les drains des transistors T1 et T2 sont alimentés par les deux branches d'un miroir de courant ayant un rapport de recopie k inférieur à 1. La première branche du miroir comprend un transistor de recopie T3 et la deuxième branche comprend un transistor de référence T4. Le transistor de recopie T3 tend à recopier le courant circulant dans le transistor de référence T4. Classiquement le rapport de recopie est égal à 1/2.

Le transistor de recopie T3 est un transistor de type P ayant sa source reliée à une borne d'alimentation Vcc et son drain est relié au drain d'un transistor T1. Le transistor de référence T4 est de la même façon un transistor de type P dont la source connectée à la borne d'alimentation Vcc et dont le drain est relié au drain du transistor T2.

Les grilles de commande des transistors T3 et T4 sont reliées entre elles et la grille du transistor T4 est reliée à son drain.

Un amplificateur différentiel AD a ses entrées reliées aux drains des transistors T3 et T4 et mesure l'écart entre les potentiels sur ces deux drains. Cet écart est nul si les courants circulant dans les transistors T3 et T4 ont un rapport égal à k. La sortie de l'amplificateur AD fournit un signal indiquant si le rapport des courants est supérieur ou inférieur à k.

Le circuit de lecture peut être complété par deux transistors supplémentaires T5 et T6 prévus pour accélérer la précharge de la ligne de bit et de la ligne de référence. Ces transistors sont commandés par un signal de précharge PREC actif pendant la phase de précharge et permettent d'appliquer une tension proche de la tension d'alimentation sur les drains des transistors de précharge T1 et T2 pendant la phase de précharge.

Le principal inconvénient de ce type de circuit est que le fonctionnement du dispositif de limitation de précharge constitué des transistors T1, T2 et des inverseurs INV1, INV2 n'est pas très satisfaisant lorsque la tension d'alimentation du circuit de lecture est faible, de l'ordre de 1,8 volts.

En effet, avec une tension maximum (1,8 volts) plus faible sur leur grille de commande, les transistors T1 et T2 sont moins passants et le contrôle du courant et du potentiel de précharge devient moins précis. Le temps de précharge de la ligne de bit est alors pénalisé. Par ailleurs, la tension drain-source des transistors T1 et T2 étant relativement faible, leur action sur la ligne de bit et la ligne de référence n'est pas complètement maîtrisée.

On pourrait envisager de modifier les caractéristiques des transistors des cellules de la mémoire afin de diminuer la valeur limite du potentiel de précharge des lignes de bit qui est de 1 volt. Cette solution nécessiterait cependant de procéder à la qualification d'une nouvelle technologie, ce qui est particulièrement long et coûteux.

On pourrait également prévoir d'utiliser de gros transistors de précharge T1 et T2 pour qu'ils laissent passer plus de courant et diminuent la durée de la précharge, cependant la tension drain-source des transistors T1 et T2 resterait la même.

La solution adoptée dans l'invention consiste à imposer sur la ligne de bit une valeur limite de potentiel de précharge référencée par rapport à la masse. Pour ce faire, la structure du circuit de lecture a été complètement modifiée.

Aussi, l'invention a pour objet un circuit de lecture pour mémoire non volatile du type comportant une matrice de cellules mémoire, le circuit de lecture étant relié d'une part auxdites cellules mémoires par l'intermédiaire d'au moins une ligne de bit et d'autre part à un générateur de courant de référence par l'intermédiaire d'une ligne de référence, lequel circuit de lecture comprend un amplificateur différentiel pour délivrer un signal représentatif de l'état d'une cellule mémoire sélectionnée parmi les cellules mémoire de la matrice caractérisé en ce qu'il comporte en outre des moyens formant miroir de courant et assurant d'autre part une précharge contrôlée de la ligne de bit et de la ligne de référence en limitant le potentiel de précharge à une valeur limite référencée par rapport à la masse.

De préférence, le générateur de courant de référence est une cellule mémoire de référence.

Selon un premier mode de réalisation de l'invention, les moyens formant miroir de courant et assurant une précharge contrôlée comportent
- un premier élément résistif connecté entre une borne d'alimentation et ladite ligne de bit,
- un second élément résistif connecté entre ladite borne d'alimentation et ladite ligne de référence,
- un premier transistor de type N dont le drain est relié à la ligne de bit et la source à la masse,
- un deuxième transistor de type N dont le drain est relié à la borne d'alimentation, la grille de commande à la ligne de bit et la source à la grille de commande du premier transistor,
- un troisième transistor de type N dont la grille de commande est reliée à la grille de commande du premier transistor, la source à la masse et le drain à ligne de référence, et
- une première source de courant connectée à la source du deuxième transistor pour polariser ce dernier;
et en ce que les entrées inverseuse et non inverseuse de l'amplificateur différentiel sont respectivement connectées à la ligne de bit et à la ligne de référence.

On obtient ainsi un potentiel de précharge de la ligne de bit qui est limitée par la tension de seuil du premier et du second transistor. Si le deuxième transistor est un transistor natif, cette valeur limite du potentiel de précharge est à peu prés égale à 1 volt. Un potentiel de précharge de même valeur est obtenu sur la ligne de référence par recopie du courant.

Pendant la phase de lecture, l'amplificateur différentiel effectue ensuite la comparaison entre le potentiel de la ligne de bit et le potentiel de la ligne de référence.

Selon un second mode de réalisation de l'invention, l'amplificateur différentiel est connecté différemment. Les moyens formant miroir de courant et assurant une précharge contrôlée comportent alors
- un premier élément résistif connecté entre une borne d'alimentation et ladite ligne de bit,
- un second élément résistif connecté entre ladite borne d'alimentation et ladite ligne de référence,
- un premier transistor de type N dont le drain est relié à la ligne de bit, la source à la masse et la grille de commande à l'entrée inverseuse de l'amplificateur différentiel,
- un deuxième transistor de type N dont le drain est relié à la borne d'alimentation, la grille de commande à la ligne de bit et la source à la grille de commande du premier transistor,
- un troisième transistor de type N dont la grille de commande est reliée à la grille de commande du premier transistor, la source à la masse et le drain à ligne de référence, et
- un quatrième transistor de type N dont le drain est relié à la borne d'alimentation, la grille de commande à la ligne de référence et la source à l'entrée non inverseuse de l'amplificateur différentiel,
- une première source de courant et une seconde source de courant connectées respectivement sur la source des deuxième et quatrième transistors pour polariser ces derniers.

D'autres caractéristiques et avantages de l'invention apparaîtront à la lecture de la description détaillée qui suit et qui est faite en référence aux dessins annexés dans lesquels :
- la figure 1, déjà décrite, représente un circuit de lecture de l'art antérieur;
- la figure 2 représente un circuit de lecture selon un premier mode de réalisation de l'invention, et
- la figure 3 représente un second mode de réalisation du circuit de lecture selon l'invention.

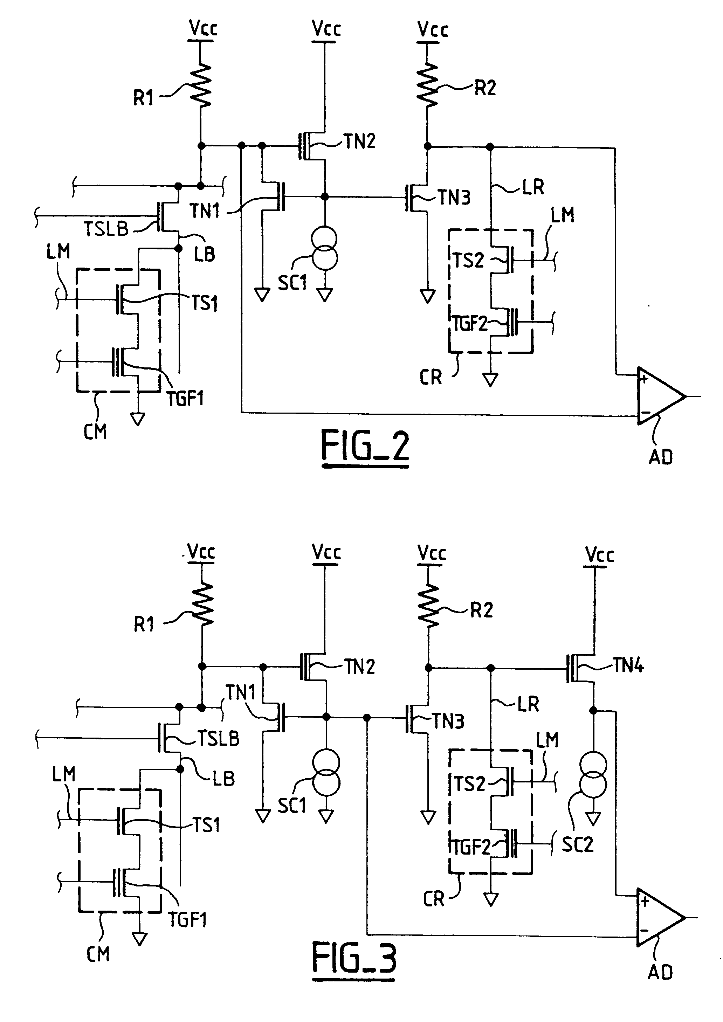

La structure du circuit de lecture de la figure 2 est relativement différente de celle du circuit de la figure 1; le dispositif qui limite le potentiel de précharge n'est plus intercalé entre les lignes de bit et un miroir de courant. Par ailleurs, la valeur limite du potentiel de précharge est désormais fixée par rapport à la masse.

Dans la figure 2, la ligne de bit LB sélectionné par le transistor TSLB est directement connectée aux moyens formant miroir de courant qui assurent également une précharge contrôlée de la ligne de bit LB et de la ligne de référence LR.

La ligne de bit LB est donc connectée à une résistance R1 qui est reliée, par son autre extrémité, à la borne d'alimentation Vcc du circuit. De façon identique, la ligne de référence LR est connectée à une résistance R2 reliée par son autre extrémité à la borné d'alimentation Vcc.

La ligne de bit LB est également connectée à une première branche d'un miroir de courant constituée des transistors TN1 et TN2 de type N. La ligne de référence LR est connectée à la deuxième branche du miroir de courant. La source du transistor TN1 est connectée à la masse; son drain est connecté d'une part à la ligne de bit LB et d'autre part à la grille de commande du transistor TN2; enfin, sa grille de commande est reliée à la source du transistor TN2 et le drain du transistor TN2 est connectée à la borne d'alimentation Vcc. Cette première branche constitue la branche de référence du miroir de courant. Cette branche de courant va permettre d'imposer une valeur limite de la tension de précharge égale à la somme des tensions de seuil des transistors TN1 et TN2. Sachant que la tension seuil du transistor TN1 est de l'ordre de 0,8 volt et que celle du transistor TN2 est de 0,2 volt, on obtient une valeur limite égale à 1 volt.

Cette branche en collaboration avec la résistance R1 va également permettre de produire un courant de référence qui est recopiée dans la seconde branche. Pendant la phase de précharge, la ligne de bit LB n'est reliée à aucune cellule mémoire CM; la résistance R1 et le transistor TN1 sont alors parcouru par ce courant de référence.

Pour que la tension de seuil du transistor TN2 soit stable, le drain du transistor TN2 est relié à une source de courant SC1.

Le courant de référence circulant à travers le transistor TN1 pendant la phase de précharge est recopié dans la seconde branche du miroir de courant. Dans cet exemple, le rapport de recopie du miroir de courant qui correspond au rapport des géométries des transistors est pris égal à l'unité et les résistances R1 et R2 ont une valeur identique égale à R.

Enfin, le circuit de lecture comporte un amplificateur différentiel AD pour comparer pendant la phase de lecture le potentiel de la ligne de bit LB au potentiel de la ligne de référence LR. A cet effet, l'entrée inverseuse de l'amplificateur est connectée directement à la ligne de bit LB alors que l'entrée non inverseuse est reliée à la ligne de référence LR.

Le circuit fonctionne de la manière suivante : pendant la phase de précharge, la ligne de bit LB est porté à un potentiel de précharge égal à 1 volt par l'intermédiaire des transistors TN1 et TN2 et de la résistance. Le courant circulant dans la résistance R1 étant le même que celui circulant dans la résistance R2, la ligne de référence est alors préchargée au même potentiel.

Pendant la phase de lecture, la sélection des cellules mémoire, CM et CR, et l'application d'une tension de lecture sur la grille de commande des transistors à grille flottante de ces cellules provoquent deux effets différents suivant que la cellule CM est effacée ou programmée.

Si la cellule CM est programmée, elle s'oppose au passage d'un courant. le potentiel de la ligne de bit LB est donc conservé alors que le potentiel de la ligne de référence tend à tomber quelque peu car la cellule de référence est parcourue par un courant de référence. L'amplificateur différentiel AD bascule alors dans un premier état.

A l'inverse, si la cellule CM est effacée, elle est parcourue par un courant supérieur au courant de circulant dans la cellule de référence CR. Le potentiel de la ligne de bit LB tend alors à tomber plus bas que celui de la ligne de référence LR. L'amplificateur différentiel AD bascule dans un état inverse.

Une variante de ce mode de réalisation est illustrée par la figure 3. Le circuit de lecture est complété par un transistor TN4 natif de type N identique au transistor TN2. Sa grille de commande est connectée à la ligne de référence LR; son drain est reliée à la borne d'alimentation Vcc et sa source est connectée à une source de courant SC2 identique à la source SC1. Dans cette variante, l'entrée inverseuse de l'amplificateur différentiel AD est connectée à la source du transistor TN2 et l'entrée non inverseuse est connectée à la source du transistor TN4. Dans cette variante, les potentiels présents sur les entrées de l'amplificateur AD sont décalés de la tension de seuil des transistors TN2 et TN4 par rapport au mode de réalisation précédent. Le fonctionnement global du circuit de lecture reste cependant le même.

## Revendications

1. Circuit de lecture pour mémoire non volatile du type comportant une matrice de cellules mémoire (CM), le circuit de lecture étant relié d'une part auxdites cellules mémoires par l'intermédiaire d'au moins une ligne de bit (LB) et d'autre part à un générateur de courant de référence (CR) par l'intermédiaire d'une ligne de référence (LR), lequel circuit de lecture comprend un amplificateur différentiel (AD) et des moyens de précharge de la ligne de bit et de la ligne de référence,
caractérisé en ce qu'il comporte des moyens formant miroir de courant et assurant d'autre part une précharge contrôlée de la ligne de bit (LB) et de la ligne de référence (LR) en limitant le potentiel de précharge à une valeur limite référencée par rapport à la masse.

2. Circuit de lecture selon la revendication 1, caractérisé en ce que le générateur de courant de référence est une cellule de référence (CR).

3. Circuit de lecture selon la revendication 1 ou 2, caractérisé en ce que lesdits moyens formant miroir de courant et assurant une précharge contrôlée comportent
- un premier élément résistif (R1) connecté entre une borne d'alimentation (Vcc) et ladite ligne de bit (LB),
- un second élément résistif (R2) connecté entre ladite borne d'alimentation (Vcc) et ladite ligne de référence (LR),
- un premier transistor (TN1) de type N dont le drain est relié à la ligne de bit (LB) et la source à la masse,
- un deuxième transistor (TN2) de type N dont le drain est relié à la borne d'alimentation (Vcc), la grille de commande à la ligne de bit (LB) et la source à la grille de commande du premier transistor (TN1),
- un troisième transistor (TN3) de type N dont la grille de commande est reliée à la grille de commande du premier transistor (TN1), la source à la masse et le drain à ligne de référence (LR), et
- une première source de courant (SC1) connectée à la source du deuxième transistor (TN2) pour polariser ce dernier;
et en ce que les entrées inverseuse et non inverseuse de l'amplificateur différentiel (AD) sont respectivement connectées à la ligne de bit (LB) et à la ligne de référence (LR).

4. Circuit de lecture selon la revendication 1 ou 2, caractérisé en ce que lesdits moyens formant miroir de courant et assurant une précharge contrôlée comportent
- un premier élément résistif (R1) connecté entre une borne d'alimentation (Vcc) et ladite ligne de bit (LB),
- un second élément résistif (R2) connecté entre ladite borne d'alimentation (Vcc) et ladite ligne de référence (LR),
- un premier transistor (TN1) de type N dont le drain est relié à la ligne de bit (LB), la source à la masse et la grille de commande à l'entrée inverseuse de l'amplificateur différentiel (AD),
- un deuxième transistor (TN2) de type N dont le drain est relié à la borne d'alimentation (Vcc), la grille de commande à la ligne de bit (LB) et la source à la grille de commande du premier transistor (TN1),
- un troisième transistor (TN3) de type N dont la grille de commande est reliée à la grille de commande du premier transistor (TN1), la source à la masse et le drain à ligne de référence (LR), et
- un quatrième transistor (TN4) de type N dont le drain est relié à la borne d'alimentation (Vcc), la grille de commande à la ligne de référence (LR) et la source à l'entrée non inverseuse de l'amplificateur différentiel (AD),
- une première source de courant (SC1) et une seconde source de courant (SC2) connectées respectivement sur la source des deuxième et quatrième transistors (TN2,TN4) pour polariser ces derniers.

5. Circuit de lecture selon la revendication 3 caractérisé en ce que le deuxième transistor (TN2) est un transistor natif.

6. Circuit de lecture selon la revendication 4 caractérisé en ce que les deuxième et quatrième transistors (TN2,TN4) sont des transistors natifs.

7. Circuit de lecture selon la revendication 3 ou 4 caractérisé en ce que les premier et second éléments résistifs (R1,R2) ont la même valeur et en ce que le rapport des géométries des premier et troisième transistors (TN1,TN3) est égal à un.
